Europäisches Patentamt

European Patent Office

Office européen des brevets

(19)

(11) Numéro de publication: **0 084 287**

**A1**

(12) # DEMANDE DE BREVET EUROPEEN

(21) Numéro de dépôt: **82402396.4**

(22) Date de dépôt: **29.12.82**

(51) Int. Cl.³: **G 05 D 23/01**

(30) Priorité: **04.01.82 FR 8200017**

(43) Date de publication de la demande:
**27.07.83 Bulletin 83/30**

(84) Etats contractants désignés:
**BE CH DE GB IT LI NL**

(71) Demandeur: **COMMISSARIAT A L'ENERGIE ATOMIQUE Etablissement de Caractère Scientifique Technique et Industriel**
**31/33, rue de la Fédération**
**F-75015 Paris(FR)**

(72) Inventeur: **Bruel, Michel**
**Presvert No. 9**
**F-38113 Veurey Voroize(FR)**

(72) Inventeur: **Soubie, Alain**
**3, rue Casimir Brenier**
**F-38120 Saint Egreve(FR)**

(74) Mandataire: **Mongrédien, André et al,**
**c/o BREVATOME 25, rue de Ponthieu**
**F-75008 Paris(FR)**

(54) **Dispositif de limitation et de contrôle de la température d'une cible reposant sur un support dans une enceinte sous vide et recevant un faisceau d'énergie et son application à des mesures thermiques.**

(57) Dispositif de limitation et de contrôle de la température d'une cible (6) reposant sur un support (5) dans une enceinte sous vide et soumise à un bombardement de particules énergétiques.

Il comprend, insérée entre le support et la cible, une membrane (1) déformable, préformée pour s'appliquer parfaitement sur la face arrière de la cible (6) de façon à emprisonner, dans l'espace compris entre le support (5) et la membrane (1), un fluide gonflé à une pression interne assurant un contact intime entre la membrane et la cible et assurant le transfert de chaleur de la membrane au support.

FIG.4

EP 0 084 287 A1

La présente invention se rapporte au domaine de la régulation thermique des cibles reposant sur un support dans une enceinte sous vide et soumises à un bombardement de particules énergétiques, de photons et/ou d'ondes électromagnétiques ayant pour effet secondaire indésirable d'en augmenter la température. Elle a pour objet notamment, bien que de façon non exclusive et non limitative, de parvenir à une limitation automatique de la température des cibles de matériau utilisées pour l'élaboration de composés semi-conducteurs à l'aide des techniques bien connues de l'implantation ionique.

En effet, lorsque l'on traite des échantillons sous vide par irradiation énergétique, le traitement apporte de l'énergie et la température des échantillons s'élève jusqu'à une valeur limite correspondant à l'équilibre avec le milieu environnant. Cette température limite dépend du rayonnement énergétique reçu et des pertes thermiques. Ces pertes thermiques sont essentiellement dues au rayonnement, à la conduction directe entre l'échantillon et son système de support ainsi qu'à la convection qui est toutefois très faible et quasi inexistante si le traitement a lieu, comme c'est presque toujours le cas, dans une enceinte sous vide poussé.

L'expérience montre que le transfert de chaleur entre l'échantillon et son support est souvent très faible. En effet, si l'on ne prend pas des mesures particulières pour renforcer ce transfert, tout se passe le plus souvent comme si l'échantillon et la face correspondante du support n'étaient pratiquement pas en contact. Par exemple, une plaquette standard de silicium, même appliquée par un petit ressort sur un support métallique massif dans une installation d'implantation ionique, peut être considérée comme isolée thermiquement sous vide.

Or, dans certaines expériences ou lors de certains traitements il est absolument indispensable d'empêcher la cible ou la plaque traitée de dépasser certai-

B 7409-3 AM

nes températures qui peuvent être nuisibles ou même totalement destructrices vis-à-vis du produit que l'on désire obtenir ; c'est le cas notamment lorsque les produits constituant la cible sont recouverts de résines qui s'altèrent à partir de 120°C.

Dans les techniques connues jusqu'à ce jour, on tentait d'éviter ces échauffements préjudiciables en utilisant de façon générale des substances molles et visqueuses capables d'adhérer à la fois à la cible ou à la plaquette traitée et à son support et dont la conductivité thermique relativement élevée assurait ainsi une certaine amélioration de l'évacuation de chaleur à partir de la cible. C'est ainsi que des graisses à base de silicone étaient souvent utilisées entre la cible et le support, lequel pouvait d'ailleurs en outre être refroidi énergiquement par des moyens classiques connus.

Ce procédé possède néanmoins certains inconvénients majeurs, notamment, celui de salir les pièces en présence, de nécessiter des manipulations pas toujours faciles dans une enceinte à vide et de ne pas être systématiquement compatibles avec n'importe quel type d'expérience.

Dans d'autres cas, on a également essayé de placer entre le support et la cible chauffée des supports souples bon conducteurs thermiques tels que par exemple des caoutchoucs siliconés ou des caoutchoucs chargés de microbilles en or ou en argent. Cette membrane est fixée de façon permanente en contact intime avec le support, par collage par exemple. L'application sous vide de la cible sur la membrane de caoutchouc permet une bonne adaptation à la forme du support et par conséquent un contact intime entre les deux pièces en présence. Cette solution, qui a l'intérêt de fonctionner de façon systématique, ne peut pas non plus toutefois être utilisée dans n'importe quelle expérience puisqu'on introduit dans l'enceinte sous vide un composé chimique éventuellement polluant ou gênant.

B 7409-3  AM

On a également essayé de réaliser ce contact thermique amélioré entre la cible et son support par injection, entre les deux, d'un gaz bon conducteur à une pression moyenne (de l'ordre de 1 Torr) de façon à créer ainsi une conduction thermique et une évacuation des calories par convection. On conçoit toutefois que la réalisation d'un tel débit gazeux dans une enceinte à vide pose des problèmes dont la solution technique est particulièrement difficile.

Jusqu'à ce jour, le problème reste posé depuis de nombreuses années et n'a pas encore trouvé de solution satisfaisante, alors même qu'il est bien connu des spécialistes que les traitements de substrats sous vide conduisent de plus en plus à des dépôts élevés d'énergie donc à des échauffements de plus en plus importants.

La présente invention a précisément pour objet un dispositif de limitation de la température d'une telle cible reposant sur un support dans une enceinte sous vide, qui fonctionne automatiquement et permet, à l'aide de moyens dont la mise en oeuvre est particulièrement simple, une limitation et un contrôle très satisfaisants de la température de la cible.

Ce dispositif se caractérise essentiellement en ce qu'il comprend, insérée entre le support et la cible, une membrane déformable, préformée à une forme telle qu'elle soit à même, sous l'effet d'une légère surpression interne, de s'appliquer de façon intime sur la face arrière de la cible, ceci même si l'élasticité du matériau est faible et telle que ladite membrane emprisonne entre elle-même et le support un fluide dont les fonctions sont d'une part, par sa pression d'assurer le plaquage de la membrane sur la face arrière de la cible et d'autre part, de transporter les calories depuis la membrane vers le support.

Dans un cas particulier de réalisation et de manière préférentielle, ladite membrane peut être mé-

B 7409-3 AM

tallique, éventuellement en un métal de faible élasticité, préformée en forme de coupelle pour s'appliquer parfaitement sur la face arrière de la cible et dont les bords profilés, en forme de S et ayant une certaine hauteur, reposent sur le support par l'intermédiaire de joints d'étanchéité.

Le fluide sous pression emprisonné dans l'espace compris entre le support et la membrane peut être statique, circuler à l'intérieur de cet espace, ou circuler à l'extérieur de cet espace.

Dans un mode de réalisation spécialement intéressant de la présente invention, ce fluide est un corps en équilibre biphasique liquide-vapeur. Ce fluide ainsi enfermé dans la membrane métallique souple et déformable se présente alors en partie sous forme liquide et en partie sous forme vapeur et peut transporter les calories à la manière d'un caloduc entre la cible chauffante et le support chargé d'évacuer les calories à l'extérieur, si la configuration générale est telle que la membrane est en contact avec la phase liquide.

Par ailleurs, la souplesse de la membrane assure, celle-ci ayant été préalablement fixée entre la cible et son support, une expansion automatique de l'espace interne sous l'effet de la différence de pression entre la pression du fluide et le vide réalisé à l'intérieur de l'enceinte dans laquelle on introduit la cible à traiter. On réalise ainsi de cette manière selon l'invention, un contact intime particulièrement favorable à l'évacuation des calories entre la surface externe souple de la membrane métallique et la face arrière de la cible chauffée.

La membrane du dispositif objet de l'invention peut être réalisée par tout moyen connu, mais il est avantageux néanmoins de recourir à un dépôt électrochimique qui permet d'obtenir les épaisseurs souhaitées avec toute la régularité possible. On réalise ainsi par exemple une membrane en cuivre électrolytique recouverte d'une couche de nickel.

Dans cette réalisation préférentielle la membrane a une forme de coupelle dont les extrémités, profilées en forme de S lui donnent une grande souplesse, ce qui lui permet sous l'effet d'une légère pression intérieure de s'appliquer parfaitement contre la face arrière de la cible chauffée.

De toute façon l'invention sera mieux comprise en se référant à la description qui suit de quelques exemples de mise en oeuvre du dispositif de limitation de la température, description qui sera faite en se référant aux figures 1 à 4 suivantes, dans lesquelles :

- la figure 1 montre le profil général d'une membrane souple métallique utilisée dans le dispositif selon l'invention, en coupe par un plan passant par l'axe de symétrie cylindrique de cette membrane,

- la figure 2 représente une forme particulière de la membrane de la figure 1,

- la figure 3 représente le principe général du montage de la membrane des figures 1 et 2 dans un dispositif de limitation et de contrôle de température conforme à l'invention,

- la figure 4 montre un autre exemple de montage d'un dispositif conforme à l'invention.

- la figure 5 montre une variante du dispositif de la figure 4.

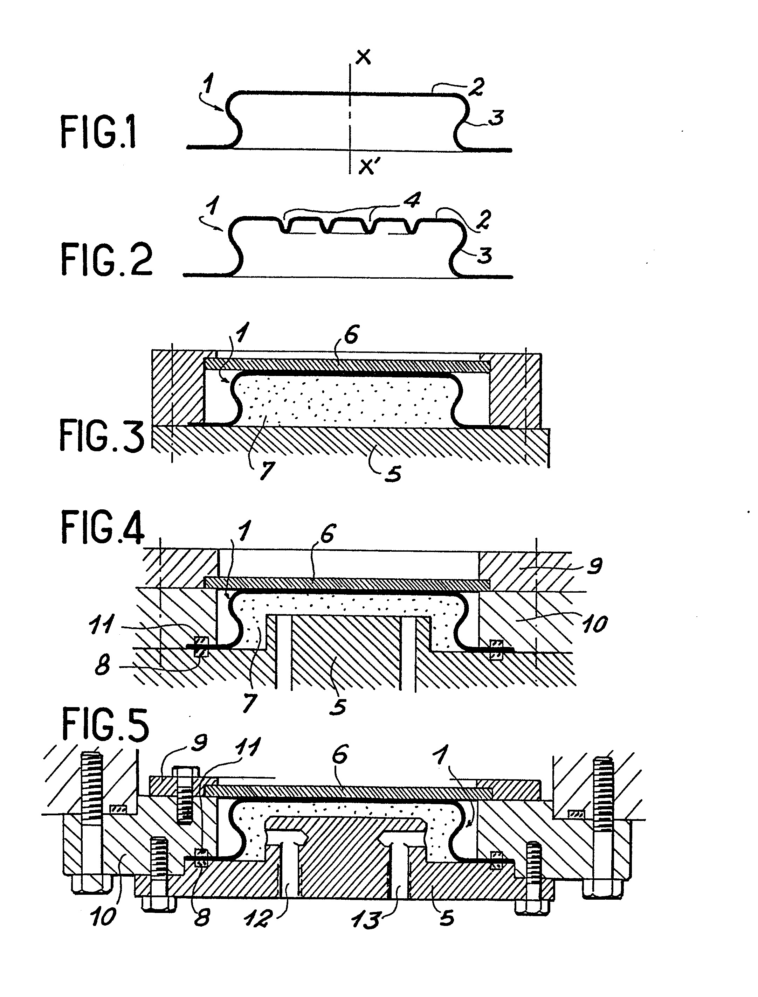

Sur la figure 1, on voit la membrane métallique souple 1, de révolution autour de l'axe vertical XX' et qui se compose essentiellement d'une partie circulaire plane 2 prolongée par des rebords 3 profilés en forme de S. La membrane 1 et ses bords 3 affectent la forme générale d'une coupelle de forme renversée. Dans l'exemple de la figure 1, la membrane 1 est en cuivre revêtu

B 7409-3 AM

d'un dépôt de nickel ; son épaisseur est de 0,02 mm et sa hauteur totale de 5 mm. Le diamètre, dont la valeur n'est pas significative d'ailleurs, atteint 50 mm.

Sur la figure 2, on a représenté une membrane 1 comparable à celle de la figure 1, mais dont la surface plane 2 possède un certain nombre de replis circulaires tels que 4 qui augmentent encore la déformabilité de cette surface et permettent une expansion meilleure contre la cible chauffante non représentée lorsque la membrane étant introduite sous vide, la pression interne du fluide qu'elle enferme tend à la dilater.

L'épaisseur des membranes des figures 1 et 2 n'est pas critique, mais l'expérience a montré que la souplesse désirable imposait une épaisseur comprise entre 0,02 mm et 0,10 mm. Dans ces conditions, la membrane ainsi préformée, réagit très bien aux variations de pression interne et vient s'appliquer parfaitement sur la face arrière de la cible chauffée,      comme le montre la figure schématique 3, dans laquelle la membrane 1 placée sur un support métallique 5 qui maintient en place la cible 6 est venue s'expanser contre la face arrière de cette dernière sous l'effet d'un fluide interne 7 gonflé à une pression de 1 à quelques dizaines de Torr.

La figure 4 montre maintenant un montage possible d'une membrane souple déformable 1 sur un support 5 d'une plaquette de silicium 6 que l'on veut doper par implantation ionique. L'ensemble des éléments de la figure 4 doit être considéré comme situé dans une enceinte sous vide non représentée. La membrane 1 est posée sur son support 5 par l'intermédiaire de joints 8 et un système d'anneaux de maintien 9 et 10 assure le maintien en place à la fois de la membrane 1 et de la plaquette de silicium 6 sur le support 5. On remarquera encore qu'entre l'anneau inférieur 10 et le rebord extrême de la plaquette 1, un second joint 11 assure l'étanchéité. En-

B 7409-3 AM

fin, et selon l'invention, l'espace interne 7 compris entre la membrane 1 et le support 5 est rempli d'un fluide en équilibre avec sa vapeur saturante dont la pression (quelques torrs) assure en liaison avec le vide régnant tout autour du système, une application très intime de la partie plane de la membrane 1 contre la face arrière 6 de la plaquette de silicium. Il en résulte que par conduction thermique les calories engendrées par le bombardement ionique de la plaquette 6 sont évacuées systématiquement à travers la membrane 1, le milieu intermédiaire que constitue le fluide 7 et le support 5.

Le fluide sous pression situé dans l'espace compris entre le support 5 et la membrane 1 peut être un liquide en équilibre avec sa vapeur, ce qui présente l'avantage de conduire à un système auto-régulateur au point de vue thermique : en effet, plus la puissance reçue par le système augmente, plus le liquide tend à chauffer et plus la tension de vapeur de la phase gazeuse augmente, ce qui conduit à une application plus rigoureuse de la membrane 1 contre la cible 6 et par conséquent à un renforcement de la conductivité thermique du système. Dans d'autres modes de réalisation, le liquide peut circuler entre une entrée et une sortie et être ainsi refroidi en permanence. D'une façon générale d'ailleurs, on peut noter l'intérêt que présente en l'occurrence le transport des calories à évacuer par un liquide, ce qui conduit à des possibilités de circulation et d'échange thermique avec d'autres fluides.

Sur la figure 5, on retrouve, portant les mêmes nombres de référence, les mêmes éléments du dispositif que sur les figures précédentes, auquel on a toutefois ajouté deux canalisations 12 et 13 (entrée et sortie) permettant la communication entre l'espace interne de la membrane 1 et l'extérieur du système. Cette communication peut servir d'une façon générale pour le rem-

B 7409-3 AM

plissage et la vidange de cet espace délimité par la
membrane métallique 1 et également, lorsque c'est le
cas, à la circulation du fluide emprisonné dans cet espace.

Dans le cas d'un fluide en équilibre liquide-
vapeur, la pression d'appui de la membrane 1 sur la cible 6 est égale à la tension de vapeur du liquide considéré à la température de l'enceinte. Il est aisé de
choisir un fluide dont la tension de vapeur atteint
quelques torrs à la température ambiante, ce qui correspond tout à fait aux gammes de pression souhaitées pour
l'application de la membrane 1 sur la cible 6, par exemple de l'eau pure.

En outre, l'utilisation d'un fluide en équilibre liquide-vapeur, lorsque la membrane est sous vide,
permet lorsque ladite membrane est soumise
extérieurement à la pression atmosphérique, de conserver
la forme de la membrane sans aplatissement ni écrasement. Ceci est dû au fait que l'on impose au fluide une
pression supérieure à sa pression de vapeur saturante,
donc la vapeur se condense et l'intérieur de la membrane
est entièrement rempli de liquide. Il est souhaitable
que le volume de liquide soit juste inférieur au volume
intérieur de la membrane, lorsqu'elle est sous vide et
que la cible est appliquée sur elle. De cette façon,
lorsqu'on casse le vide dans l'enceinte, la forme de la
membrane change très peu et cette dernière subit peu de
contrainte.

A titre d'exemple d'application du dispositif
objet de l'invention, on décrira maintenant des expériences d'implantation ionique sur du silicium cristallin.

Il est bien connu des Hommes de Métier que
dans la gamme d'énergie utilisée pour l'implantation ionique de plaquettes de silicium, il existe pour chaque

B 7409-3 AM

ion une relation entre la dose (nombre d'ions par $cm^2$) et la température du substrat qui délimite deux types de comportement du silicium. En d'autres termes, pour une dose d'irradiation ionique donnée, il n'existe plus de risque d'amorphisation du silicium dès lors que la température du substrat dépasse une température caractéristique de la dose ; par ailleurs, il existe également une température limite T au-dessus de laquelle, quelle que soit la dose d'irradiation, aucune implantation ionique ne peut conduire à l'amorphisation du substrat.

Les tests réalisés avec le dispositif objet de l'invention ont utilisé l'ion phosphore pour lequel la température limite T est relativement basse (157°C) et la variation de la dose d'amorphisation très rapide au voisinage de la température ambiante. Des implantations d'ion phosphore ont été effectuées dans les conditions suivantes :

| Energie keV | Dose | Densité de courant |
|---|---|---|
| 200 | $5.10^{14}$ $cm^{-2}$ | 5 $\mu A$ $cm^{-2}$ |
| 200 | $7.10^{14}$ $cm^{-2}$ | 5 $\mu A$ $cm^{-2}$ |
| 200 | $10^{15}$ $cm^{-2}$ | 5 $\mu A$ $cm^{-2}$ |
| 200 | $1,2.10^{15}$ $cm^{-2}$ | 5 $\mu A$ $cm^{-2}$ |

Ces implantations ont été réalisées avec une densité de puissance de 1 $W/cm^2$, ce qui, en l'absence de tout système de refroidissement spécial, aurait élevé la température de la cible d'au moins 300°C. Avec le dispositif de limitation de température objet de l'invention, les plaquettes de silicium n'ont pas dépassé une température moyenne de 40°C. En effet, les plaquettes irradiées à une dose de $10^{15}cm^{-2}$ et $1,2.10^{15}cm^{-2}$ sont très nettement amorphisées, les plaquettes irradiées à $5.10^{14}cm^{-2}$ et $7.10^{14}cm^{-2}$ présentent des signes d'amorphisation moins marqués. Or, si la température avait dé-

B 7409-3 AM

passé 40°C, aucune de ces quatre plaquettes ne présenterait des signes d'amorphisation.

Enfin, le dispositif objet de l'invention peut trouver d'autres applications : le contrôle de la température de la cible ou la mesure de la puissance calorifique apportée à la cible par le faisceau énergétique. On peut également, en l'absence de tout apport énergétique, modifier la température de la cible ou, dans le cadre d'une implantation ionique, modifier et maîtriser la température de la cible ou encore, dès la fin de l'implantation, ramener rapidement la cible à une température de référence (trempe).

B 7409-3 AM

REVENDICATIONS

1. Dispositif de limitation et de contrôle de la température d'une cible (6) reposant sur un support (5) dans une enceinte sous vide et soumise à un flux d'énergie, notamment lors d'une implantation ionique, caractérisé en ce qu'il comprend, insérée entre le support et la cible, une membrane (1) déformable, préformée à une forme telle qu'elle puisse, sous l'effet d'une légère surpression interne, s'appliquer de façon intime sur la face arrière de la cible et telle que ladite membrane emprisonne dans l'espace compris entre elle-même et le support, un fluide gonflé à une pression interne assurant un bon contact thermique entre la membrane et la cible.

2. Dispositif selon la revendication 1, caractérisé en ce que la membrane est métallique.

3. Dispositif selon l'une quelconque des revendications 1 et 2, caractérisé en ce que la membrane est réalisée par dépôt chimique ou électrochimique de cuivre et/ou de nickel.

4. Dispositif selon l'une quelconque des revendications 1 à 3, caractérisé en ce que la membrane a une forme de coupelle dont les rebords sont profilés en forme de S.

5. Dispositif selon l'une quelconque des revendications 1 à 4, caractérisé en ce que la membrane repose sur le support par l'intermédiaire de joints d'étanchéité.

6. Dispositif selon l'une quelconque des revendications 1 à 5, caractérisé en ce que le fluide est statique.

7. Dispositif selon l'une quelconque des revendications 1 à 5, caractérisé en ce que le fluide circule à l'intérieur de l'espace interne compris entre la membrane et le support.

B 7409-3 AM

8. Dispositif selon l'une quelconque des revendications 1 à 5, caractérisé en ce que le fluide circule à l'extérieur de l'espace interne.

9. Dispositif selon l'une quelconque des revendications 6, 7, 8, caractérisé en ce que le fluide est un corps en équilibre diphasique liquide-vapeur.

10. Dispositif selon la revendication 9, caractérisé en ce que le fluide est de l'eau pure.

11. Dispositif selon l'une quelconque des revendications 9 et 10, caractérisé en ce que le liquide occupe la plus grande partie du volume intérieur de la membrane de telle façon que lorsque celle-ci est soumise à la pression atmosphérique extérieure, le liquide maintient la forme de la membrane en évitant ainsi l'écrassement et la fatigue de ladite membrane.

12. Dispositif selon l'une quelconque des revendications 9 à 11, caractérisé en ce que le fluide en équilibre diphasique transfère l'énergie calorifique par effet caloduc.

13. Application du dispositif, selon l'une quelconque des revendications 1 à 12, au contrôle de la température de la cible.

14. Application du dispositif, selon l'une quelconque des revendications 1 à 12, à la mesure de la puissance calorifique apportée à la cible.

FIG.1

FIG.2

FIG.3

FIG.4

FIG.5

# 0084287

Numéro de la demande

EP 82 40 2396

## Office européen des brevets

## RAPPORT DE RECHERCHE EUROPEENNE

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | IBM TECHNICAL DISCLOSURE BULLETIN, vol. 22, no. 3, Août 1979, pages 1026-1028, New York, US<br>S. OKTAY et al.: "Compliant heat pipe for cooling semiconductor chips" * page 1026, ligne 1 - page 1027, ligne 5; figur 1 * | 1 | G 05 D 23/01 |
| A | US-A-3 957 107 (SECRETARY OF THE AIRFORCE)<br>* Colonne 2, ligne 27 - colonne 4, ligne 14; figures 1,2 * | 1 | |
| A | US-A-3 225 820 (GENERAL PRECISION)<br>* Colonne 3, ligne 67 - colonne 4, ligne 13; figure 3 * | 1 | DOMAINES TECHNIQUES RECHERCHES (Int. Cl. 3) |
| A | IBM TECHNICAL DISCLOSURE BULLETIN, vol. 22, no. 8A, janvier 1980, page 3166, New York, US<br>F.E. ANDROS et al.: "Heat transfer apparatus" * En entier * | 1 | G 05 D<br>H 01 L |

Le présent rapport de recherche a été établi pour toutes les revendications

| Lieu de la recherche<br>LA HAYE | Date d'achèvement de la recherche<br>08-04-1983 | Examinateur<br>HOUILLON J.C.P.L. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03.82